# EUROPEAN PATENT APPLICATION

(11) **EP 0 971 419 A2**
(43) Date of publication of application: **12.01.2000**
(21) Application number: 99500098.1
(22) Date of filing: 09.06.1999
(51) Int. Cl.: H01L 31/04

(54) **Dynamical thermophotovoltaic system**

(30) Priority: 10.06.1998 IT GE980048
(71) Applicant: Trimboli Longueto, Adriano, 07800 Ibiza (ES)
(72) Inventor: Trimboli Longueto, Adriano, 07800 Ibiza (ES)

(57) **Abstract**

Integrated thermophotovoltaic component, characterised by the fact of being constituted of one or more photovoltaic cells (2,13) placed on a metallic support (3,9) containing channels (4) in which is flowing a selective liquid (109).

## Description

The present invention refers to a dynamical thermophotovoltaic system, particularly to integrated thermophotovoltaic components.

The integrated themophotovoltaic system according to the present invention comprises components which can substitute the normal building elements, such as tiles, walls, glass partitions or similar. In the case of being additionally employed photovoltaic components, the output is maintained constant on the traditional photovoltaic cells by means of the chamber of thermal liquids being the object of the present patent. Such components can be either opaque or transparent. In the case of employing transparent components, these can be used not only on the roofing of the building, but also in the perimetric walls, thus increasing the surface capturing the solar energy. According to the present invention, the liquid circulating in the solar components, heated by the solar energy, transfers heat to a suitable accumulating system which stores this heat to release it thereafter for a subsequent utilisation.

In accordance with a main feature of the present invention, a System has been carried out for control of the temperature and cooling of the photovoltaic cells of any kind, thanks to which in the controlled ambient are obtained constant temperatures and constant maximum outputs.

The present invention will be better described making reference to the drawings herewith enclosed in which:

Figure 1.- Shows a top view partially in section of an opaque integrated thermophotovoltaic component according to the present invention.

Figure 2.- Shows a detail in section of figure 1.

Figure 3, 4, 5.- Show partially in section more executive forms of opaque integrated thermophotovoltaic components according to the present invention.

Figure 6.- Shows a non-complete integrated transparent themophotovoltaic component.

Figures 7, 8.- Show partially in section more executive forms of integrated transparent themophotovoltaic components according to the present invention.

Figure 9.- Shows an enlarged section of an integrated transparent themophotovoltaic component.

Figure 10.- Show an executive form which is an alternative of that shown in figure 9.

Figures 11, 12.- Show top views of executive forms of components according to figure 10.

Figure 13.- Shows a view in lateral raising in section of a building with an installation enjoying the integrated thermophotovoltaic components according to the present invention.

Figure 14.- Is a view in lengthways section of pseudo thermic transparent glass-glass according to the invention.

Figure 15.- Is an analogous view of that of figure 13, illustrating in section a building with an installation enjoying the integrated thermophotovoltaic components according to a further executive form of the present invention.

Figure 16.- Represents in a schematic mode the "summer" cycle of the installation of the building of figure 15.

Figure 17.- Represents in a schematic mode the "winter" cycle with supplementary heat contribution from a boiler of the "northern" side of the building of figure 15.

Figure 18.- Represents in a schematic mode the "winter" cycle of the building of figure 15, by means of the employment of the heat stored in the saline eutectic mixtures or polymeric materials of heat accumulation.

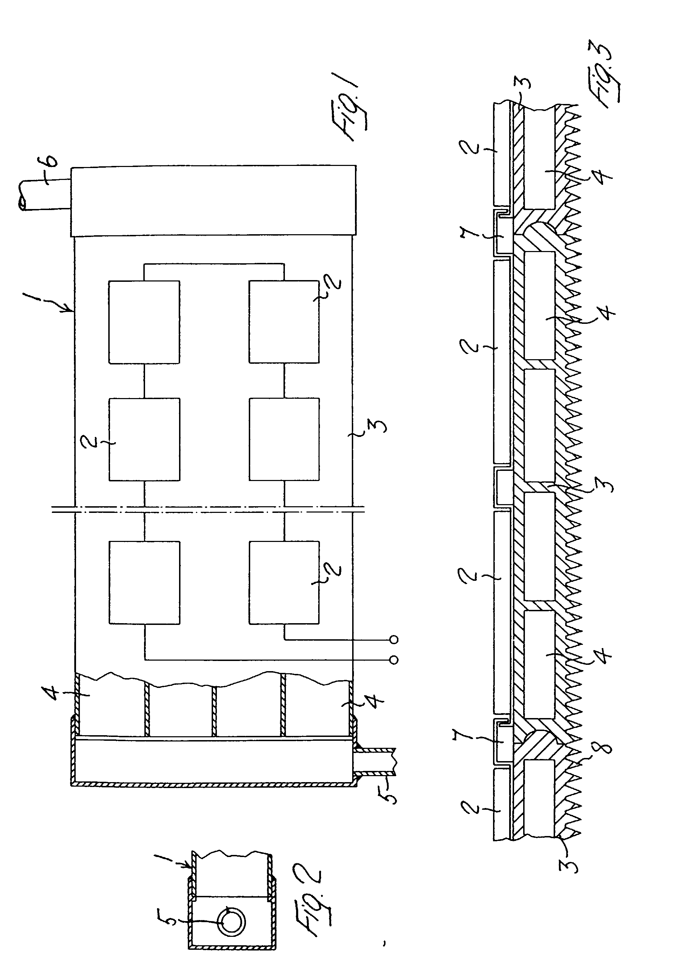

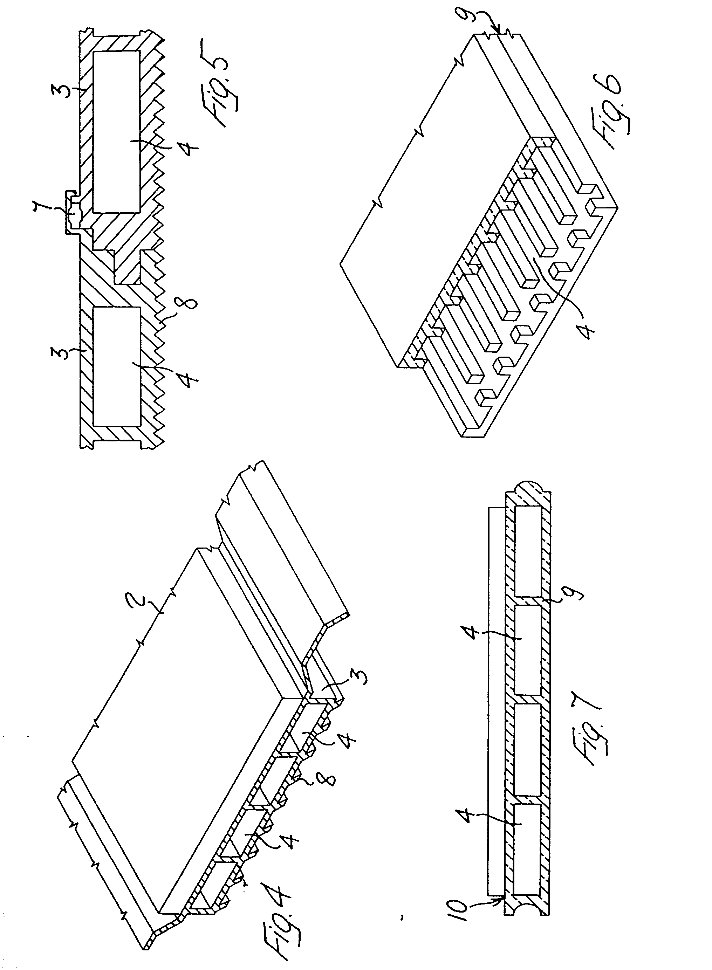

In figure 1 is shown an integrated thermophovoltaic component 1. The photo-voltaic cells, which can also be of the traditional type, are connected in series and supply electricity to an electric circuit which is not shown. The photovoltaic cells 2 are placed on a metallic support 3 and covered with glass. The metallic support 3 is internally hollow and contains the channels 4. Such channels 4 are communicating with each other, in them is running a selective liquid preferably constituted by a glycol containing oxides and pigments with the characteristic of being transparent to the visible radiation and opaque to the infrared rays. Said selective liquid enters cool from the tube 5 and comes out hot from the tube 6. In figure 2 is shown the joining, by means of a welding between the component 1 and the tube 5.

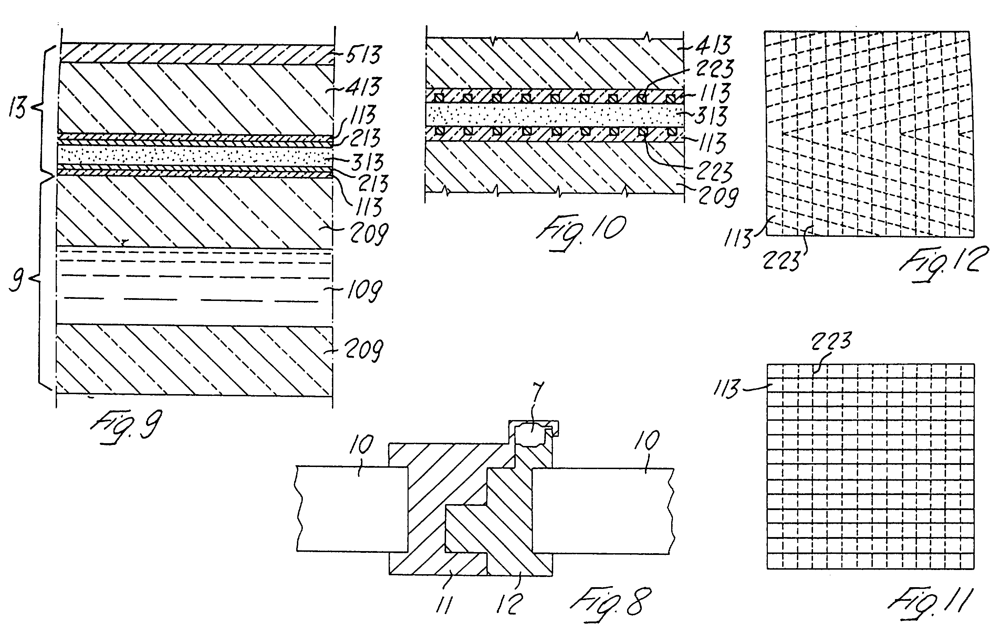

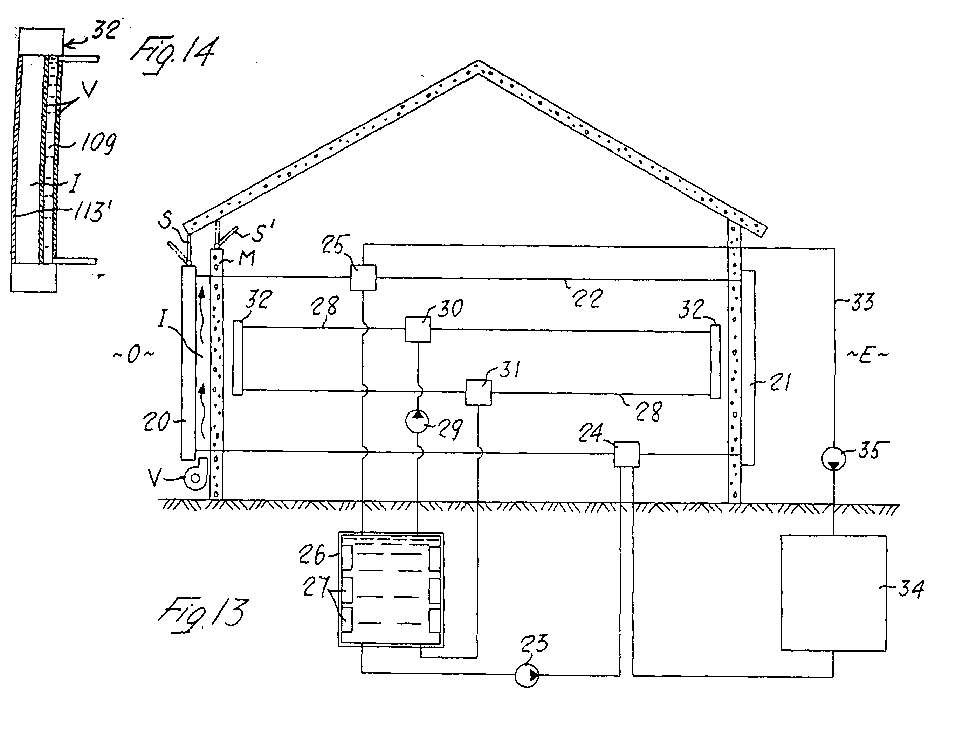

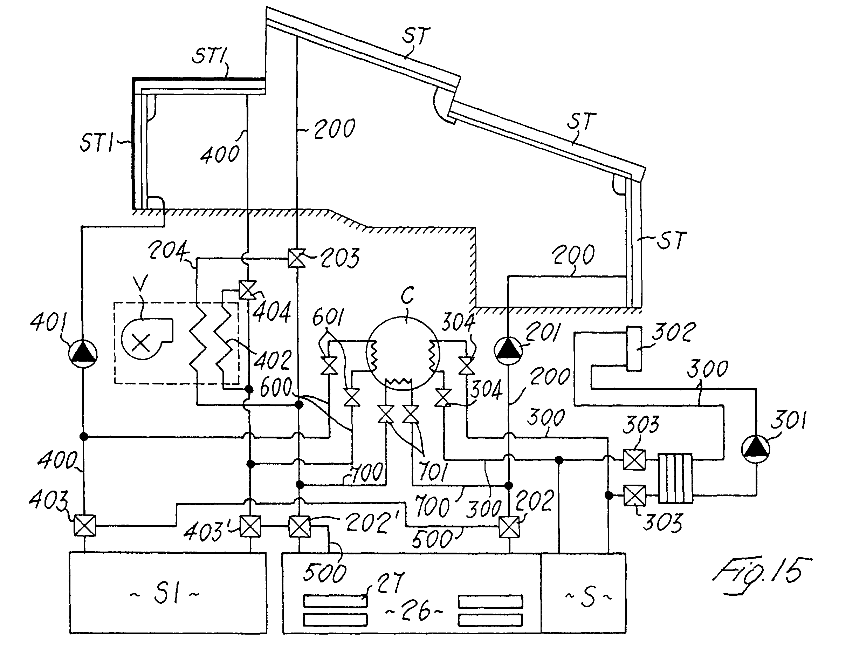

In figures 3, 4, 5 are illustrated diverse executive forms of opaque integrated thermophotovoltaic component, to equal parts correspond equal numeration. As it can be seen, the components illustrated are well connectable and compoundable with each other because the have lateral profiles which allow the noggnig of one component with the other. In the figures are shown only some possible solutions for the nogging. The photovoltaic cells 2 are inserted into the component, i.e. they are not in relief. Between two contiguous components can be created the narrow channel 7, into which can be inserted the threads of the electric circuit connected to the photovoltaic cells 2, as well as small tubes of an alternative hydraulic circuit.

The lower profile of the integrated thermophotovoltaic component can have diverse types of alettes 8. The illustrated components can be placed both on the roofing of a building and inserted in its permetric walls. The alettes 8 allow so receiving or transferring heat to the walls by conduction, thus heating by convection and irradiation the internal cavities.

According to what has been said up to now, it is evident that the solar radiation is in part absorbed by the photovoltaic cells, in part by the selective liquid which is flowing in the channels 4, and in part is transferred by conduction to the walls of the building. In this way, the global temperature of the integrated thermophotovoltaic component is constantly maintained in the interior of the filed in which it has its maximum output.

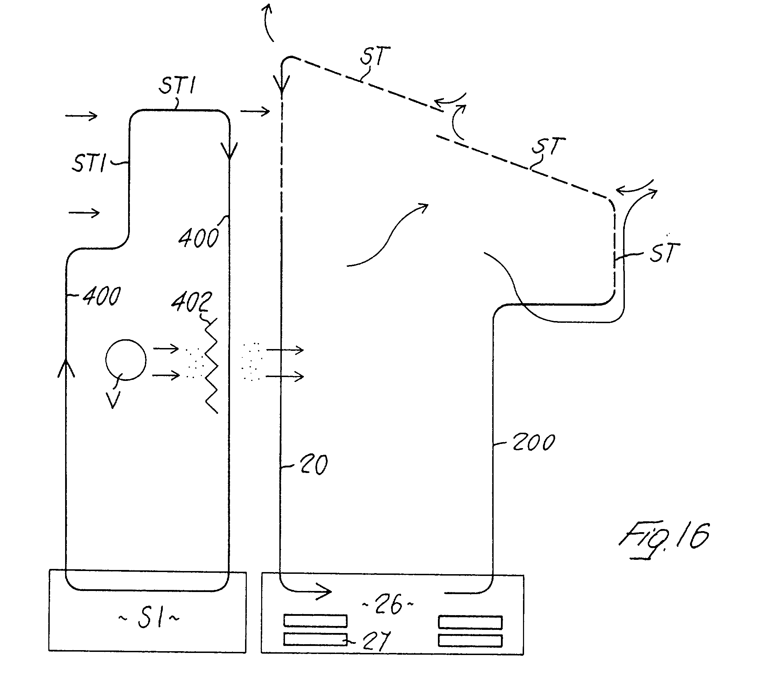

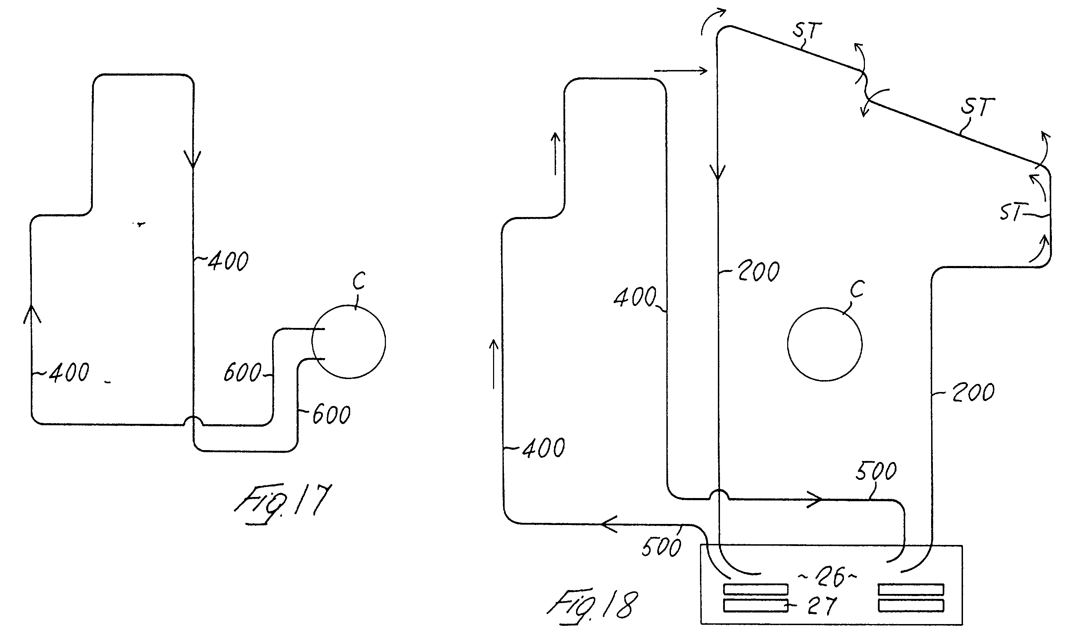

The figures 6, 7, 8, 9, 10, 11, 12 shows executive forms of integrated thermophotovoltaic transparent components. In such components, the part 9 containing the channels 4 is of glass. The canalisation is visible in figure 6. In figures 7 and 8 are shown the sections of integrated thermophotovoltaic components 10 with profiles suitable to be embedded one into the contiguous one. To equal parts correspond equal numerations. In figure 8 the embedment is effected by means of opportune metal parts 11, 12. Also in this case is employed a small channel 7 for the electric cables and the small tubes.

The integrated thermophotovoltaic components 10 are not constituted by traditional photovoltic cells, in the contrary case, their characteristic of transparence would be less seen. Figure 9 shows an executive form of an integrated thermophtovoltaic component in section. The parts 209, as it has already been said, are of glass and constitute the canalisation for the selective liquid 109. This selective liquid is of the known type, prevalently on the base of glycol. The surface 113 is a glass of the known type treated with S02, Ti02 or Ru02. The surface 213 is a conductive surface, the liquid 313 is an electrolytic solution. The part 413 is constituted by another glass, the surface 513 of which may not be plain, but machined in such a way that solar rays having different inclinations can be captured. The two faces of glass are peripherically welded together, letting between the same a microchamber containing the electrolyte. To improve the transport of electric energy by the conductive material, this may be preferably constituted by metallic threads 223 (figures 10, 11, 12) on the base of very conductive metals. Such threads, which must be embedded in the thickness of the glass, can be recitularly arranged, on different planes, for instance, as shown in figures 11 and 12 to cover in an optimal way the whole surface of the integrated thermophotovoltaic component.

These conductive reticules, which obviously must not intersect each other and which, consequently are carried out on different planes or faces, can be also carried out by means of different procedures and, for instance, by means of serigraphy procedures or laser. The integrated thermophotovoltaic components 10 can constitute glass partitions of the building. Their function is quite analogous to that described in the case of opaque components. In this case, there is existing passage of light and heat by convection and irradiation from the integrated thermophotovoltaic component to the internal cavities.

The photovoltaic part 13 of such components can also be placed on the metallic parts 3 of the opaque integrated thermophotovoltaic components instead of the traditional photovoltaic cells 2.

The integrated thermophotovoltaic components described up to now can be utilised, beside for generating electric current or for any other type of use, also for a dynamical heating system, one executive form of which is shown in figure 13. In said figure is shown a section of a building, on the lateral walls of which are placed components 20, 21. For instance, the component 20 is turned westwards and the 21 eastwards. In the morning, only the component 21 is turned to the sun and, consequently, only this internal part of the building is now heated. The selective liquid which is circulating in the hydraulic circuit 22, impelled by the pump 23, with an opportune regulation of the valvular complexes 24, 25 only circulates in the right hand branch, since the left-hand one is not heated by the component 20 which, during the morning, is in the shadow. These selective hot liquid enters into the cistern 26 which is the lung of the heating installation. At its inside are to be found more metallic elements 27 which contain materials, such as, for instance, eutectic saline mixtures, polymeric materials or other suitable materials having a low melting temperature, for instance, of the order of +18°C. Said elements 27 are closed in tight containers immerged in the selective liquid contained in the cistern 26 and remove the heat from said liquid.

The cooled liquid is sent back to the component 21 of the pump 23.

If in the cavities turned westward (as northwards and southwards) the temperature is too lows, it will be compensated by the heating circuit 28. This is driven by a pump 29, the selection of the branches to be activated is effected by valvular complexes 30, 31 The selective liquid which circulates in the circuit 28 is heated in the cistern 26 thanks to the heat which is transferred to it by the elements 27 containing the polymeric and/or eutectic compounds. In the example treated, the selective liquid is made circulate only in the left side branch to heat the westward cavities through the thermic shields 32. Such thermic shields can be of the glass-glass type, otherwise of the glass-aluminium type, or even of the aluminium-aluminium type. In figure 14 of the drawings herewith enclosed is illustrated a thermic shield 32 of the glass-glass type. Such a thermic shield comprises, as indicated before, a glass plate 113' suitable treated with metallic oxides, thus to make it conductive on one surface, and an interstice made between two glass plates V in which flows the selective liquid 109, being the plate 113' and the interstice in which is flowing the selective liquid 109 in their turn separated by an interstice I in which is activated by means of (non-represented) suitable fans a forced air circulation. The effect of "thermic shield" of such a structure results evident. As a matter of fact, the plate 113' will not allow the passage of the ultraviolet rays, but letting pass instead the infrared ones, as well as those of the visible spectrum. The radiations of the infrared ones, in their turn, will be absorbed by the selective liquid 109 circulating in the interstice between the glass plates V, whereas the radiations of the visible spectrum will pass without being disturbed also through the screen formed by the plates V and by the selective liquid circulating in them.

It is evident that when the sun is at the west, i.e. in the afternoon, the circuit 22 of the selective liquid will be activated only in the left-hand circuit and in the circuit 28 will circulate selective liquid only in the right-hand branch to heat the cavities at the east.

For reasons of simplicity has been explained the function only of the eastward and westward components, being the function of the southward components and that of those placed on the roofing quite analogous to these, rather really, the southern wall, thanks to its position, has a greater function period and can allow the heating of all the rooms turned elsewhere. The northern wall instead only receives heat from the components arranged in all the other walls.

During the summer periods, the accumulated heat is high, the heating circuit 28 is not operating, in such a case the elements 27 of the cistern 26 are saturated, being their function secured for half quantities of energy; for this reason the valvular systems 24, 25 allow the selective fluid to enter into the circuit 33 impelled by the pump 35 to "accumulate" the heat in another container or cistern 34 installed underground, for instance. Such energy can be utilised by means of a heat exchanger to transfer it to other elements and use it when necessary.

To be able to increase the surface which captures the solar energy, the walls can be substituted by integrated thermophotovoltaic components, which are transparent and opaque; these latter, deprived of the photovoltaic cells can be painted or plastered; for this reason, the whole outside surface of the building can be a surface which captures the sunbeams, making that the proper building is completely autonomous from the energetic point of view.

According to a variant of the invention, illustrated at the left-hand part of the building of figure 13, between the component 20 and the wall M of the building is foreseen an interstice I. Fans V procure a forced air circulation in said interstice I. In select positions said interstice is put in a position to communicate with the external ambient by means of the valves or shutters S, and with the internal ambient of the building by means of the valves or shutters S'. Consequently, when the heat in the components 20 results excessive because of an exposition to a particularly hot sun, for which reason the proper components 20 might not operate to the best of their yield, opening the valves S is determined an air flush towards the outside atmosphere which cools the components 20. On the contrary, if there is a need to increase the heating of the internal ambient of the building, opening the valves S' a hot air flush is introduced into the building.

In regard to the executive form of figure 15, with ST1 are indicated the thermic screen of the northern side of the building, and with ST the thermic screens of the southern side of the same building. The thermic screens ST are connected to each other by a circuit of fluid 200 in which is circulating the selective liquid contained in the cistern 26. The circulation is activated by the pump 201 and in two ends of the fluid circuit 200 are inserted, respectively above and below of said circuit, by-pass valves 202, 202' which communicate with said cistern 26 containing the eutectic elements 27. The thermic screens of the northern circuit of the building are in their turn connected to each other by a fluid circuit 400 making the head of a tank S1 with the interposition of by-pass valves 403.

A circuitry branching of fluid 500 connects on one hand the by-pass valve 202 of the circuit 200 with the by-pass valve 403 of the circuit 400, and on the other hand the by-pass valve 403' of the circuit 400 with the by-pass valve 202' of the circuit 200, for the purposes which will be described here below.

In the circuit 200 is inserted in parallel, with the interposition of a two way valve 203, a radiating element 204, whereas in the circuit 400 is inserted in parallel, with the interposition of a two way valve 404, a radiating element 402. Both radiating elements 204 and 402 are subject to the action of a fan V.

With C has been indicated a boiler from which go out, by means of suitable heat exchangers, three different circuits of heating fluid, and these are precisely the circuits indicated with 300, 600 and 700.

In regard to firstly the circuit 300, this comprises on the branches of inlet and outlet, two interception valves 304. Such a circuit makes the head on one hand of a sanitary water tank S, and on the other hand, by means of the by-pass valve 303, communicates with a radiating element 302, with the interposition of a circulation pump 301.

The circuit 600 communicates by means of the interception valves 601, with the two ranches, of forward and return flow, of the circuit 400, below the by-pass valves 403 and 403'.

The circuit 700 communicates, by means of the interception valves 701 with the two branches of forward and return flow of the circuit 200.

The function of the installation described will become evident.

In regard to firstly the figure 16, this schematically represents the "summer" circuitry condition of the installation. In this condition, the by-pass valves 202 and 202' put the circuit 200 in communication with the cistern 26, through which the heat captured by the thermic screens St will be carried by the selective liquid in it circulating in the cistern 26, and stored in the eutectic elements 27. The northern circuit 400 which in this condition is insulated from the circuits 200, transports the heat of the thermic screens ST to the cistern S which contains water. At the same time is activated the circulation of relatively cold water through the radiator 402, by opening of the valve 404, by which the fan V determines with its action a humidification of the ambients, beside a ventilation of the same by means of the ventilation openings foreseen in the thermic screens ST.

In figure 17 has been illustrated a winter condition in which, in order to increase the hear of the northern side of the building, the circuit 400, through the circuit 600, is connected to the boiler C, by means of opening of the valve 601, being closed the by-pass valves 403, 403'.

Finally, in figure 18 is illustrated the "winter" condition of the installation of the whole building, with heating by means of the heat stored in the eutectic elements 27 contained in the cistern 26. In this condition, the eutectic liquid is made circulate from the cistern 26 either through the circuit 200 or through the circuit 400, by means of the elements of the connection circuit 500.
Finally, by opening of the valves 304, hot sanitary water will be supplied to the tank S and, in case of necessity, through the by-pass valves 303 and the pump 301 also to the radiating elements 301.

From the above description will result evident the advantages of the present invention.

The system according to the invention is constituted of a series of components, denominated thermic screens, the primary function of which is the capacity of recuperating 75% of the solar radiation and managing this energy as a bioblimatical regulator, equilibrating the external and internal thermal differences of the building through the walls or the glass partitions of perimetric tamponage. The thermic and photovoltaic shields are executed in several models, with employment of recyclable materials on the base of glasses, aluminium and polycarbonates. The components, with particular adaptations, can be integrated into the tamponage coverings and into the coatings of the buildings, enabling the substitution of traditional opaque or transparent materials, without compelling the projector to use specific architectural solutions.

Thanks to the system according to the invention, the external walls are no longer the unique barriers between the internal and the external climate, but they transform through the thermic shields fed by the solar energy into:
1.- Regulators of the luminous radiation,
2.- Producers of thermal energy,
3.- Producers of photovoltaic electricity,
4.- Substitutive elements of walls, traditional glass partitions, roof-tiles or other traditional covering materials.

The system associates a circulation of liquids and air, through the interstices of the thermic shield and therefore between the diverse walls and ambients obtaining a uniform internal microclimate, with a great energetic saving.

A further advantage, as compared to the traditional technologies, is the special form of "double-body sandwich" which allows the circulation of a selective liquid with the function of absorbing the radiation I.T. associated to a complete transparence to the visible which allows the passage of light to the interior of the lodging, being possible a control of the intensity of the same.

A building projected with preferential orientation North-South will have a strong solar incidence on the facade exposed to the South, where will be originated an excess heating particularly during the summer months, in his case, the system with thermic shields will allow to take advantage of the thermic differential between the two facades for being able to compensate the temperatures through a regulating exchange and a chemical accumulation.

It will therefore become evident that, acting in the proper mode on all the elements of the system, it is possible to provide for an optimal thermoregulation of the ambients of a building, supplying to the same a temperate microclimate during all the hours of the day and in all the seasons.

Besides, it is clear that the present invention controls the temperature of the photovoltic cells of any type with thermic exchange, cooling them or heating them, so as to maintain constant the coefficient of exercise on the aforementioned cells and therefore obtain the maximum electric output.

The present invention is of course not limited to the executive forms illustrated and/or described, but it comprises all those executive variants and modifications entering in the ambit of the invention as claimed hereinafter.

## Claims

**1.** Integrated thermophotovoltaic component, characterised by the fact of being constituted of one or more photovoltaic surfaces (2, 13) and of means (3, 9) containing channels (4) in which is flowing a selective liquid (109).

**2.** Integrated thermophotovoltaic component according to claim 1, characterised by the fact of comprising means for control of the temperature and cooling of the photovoltaic cells of any type, so as to obtain constant temperatures and constant maximum outputs.

**3.** Integrated thermophotovoltaic component according to claim 1, characterised by the fact that its edges have such a form that they can be embedded with other components of the same type.

**4.** Integrated termophotovoltaic component according to the foregoing claims, characterised by the fact that it is constituted of a metallic part (3) having alettes (8) on the lower edge.

**5.** Integrated thermophotovoltaic component according to the foregoing claims, characterised by the fact that the photovoltaic surface (13) is constituted by a glass (113) treated with S02, TiO2, RuO2, by a conductive material (213), by an electrolytic solution (313), by a glass (413) having a machined and/or worked surface (513).

**7.** Integrated thermophotovoltaic component according to claim 6, in which the conductive material (213) is preferably constituted by metallic threads (223) arranged in any orderly mode, and/or by serigraphy tanks of electric conductive materials or similar.

**8.** Integrated thermophotovoltaic component according to the claim from 1 through 7, characterised by the fact that it is constituted of a part (9) in glass (20).

**9.** Integrated thermophotovoltaic component according to any of the foregoing claims, characterised by the fact that it can be placed on the roof of a building and on its perimetric walls.

**10.** Integrated thermophotovoltaic component according to the foregoing claims, characterised by the fact that, in absence of the photovoltaic part (2, 13), the metallic part (3) can be plastered.

**11.** Integrated thermophotovoltaic component according to the foregoing claims, in which said selective liquid is constituted by a liquid having a low freezing point, such as, for instance, a glycol, containing in mixture and/or suspension metallic oxids, and preferably oxid of titanium or others.

**12.** Method to take advantage of the thermal energy supplied by integrated thermophotovoltaic components in a building comprising the phases of:
- heating of a selective liquid passing to the interior of an integrated thermophotovoltaic component (20, 21) exposed to the solar radiation.
- Passage of such a selective hot liquid to the interior of a cistern (26) containing metallic containers containing at their inside materials having a low melting point of the order of +10° to +30°C.
- - heating of such elements (27) contained in the cistern (26) at work of the selective hot liquid in which they are immerged.
- Deviation of the selective hot liquid to the interior of a collector (34) in the case that the heat accumulating elements (27) contained in the cistern (26) should be saturated.
- Recycling of the cooled selective liquid to the interior of an integrated themophotovltaic component (20, 21) exposed to the solar radiation.
- Heating of selective liquids at the interior of the cistern (26) at work of the recuperated heat emitted from the elements (27) in relation of heat exchange with said containers.
- Circulation of such hot liquids on the components of internal radiant thermic shields (32) placed in the building.

**13.** Device for acting the method according to claim 12, characterised by the fact of comprising:
- integrated thermophotovoltaic components according to claims 1-9 placed on the whole external surface of the building.
- A circuit (22) connected to them an impelled by a pump (23) and controlled by valvular complexes (30, 31), comprising radiant components (32) placed in each cavity of the building.
- A cistern (26) comprising metallic elements (27) containing materials having a low melting temperature, in which passes either the circuit (28) or the circuit (27).
- An auxiliary container (34) connected by means of a circuit (33) impelled by a pump (35) to the valvular complexed (24, 25) of the circuit (22).

**14.** Method according to the foregoing claims 12 and 13 in which said materials with a low melting temperature are constituted by mixtures of eutectic salts, or by polymers, otherwise diverse inorganic or organic compounds of the foregoing ones having a low melting point, preferable comprised in the field from +10° to 35°C.
The present invention is of course not limited to the executive forms illustrated and/or described, but it comprises all those executive variants and modifications entering in the ambit of the invention as claimed hereinafter.
